# EUROPEAN PATENT SPECIFICATION

(11) **EP 4 408 133 B1**
(45) Date of publication and mention of the grant of the patent: **16.09.2026**
(21) Application number: 23813260.9
(22) Date of filing: 05.12.2023
(51) Int. Cl.: H05K 1/14, H05K 1/11, G06F 1/16, H02J 50/10, G04G 17/04

(54) **WEARABLE ELECTRONIC DEVICE COMPRISING SUBSTRATE ASSEMBLY**
TRAGBARE ELEKTRONISCHE VORRICHTUNG MIT SUBSTRATANORDNUNG
DISPOSITIF ÉLECTRONIQUE HABITRONIQUE COMPRENANT UN ENSEMBLE SUBSTRAT

(30) Priority: 05.12.2022 KR 20220167576; 10.01.2023 KR 20230003736
(43) Date of publication of application: 31.07.2024
(73) Proprietor: Samsung Electronics Co., Ltd., Suwon-si, Gyeonggi-do 16677 (KR)
(72) Inventor: LEE, Wooram, Suwon-si, Gyeonggi-do 16677 (KR); PARK, Seho, Suwon-si, Gyeonggi-do 16677 (KR)
(74) Representative: Gulde & Partner
(86) International application number: PCT/KR2023/019908
(87) International publication number: WO 2024/123049

(56) References cited:
- WO-A1-2020/235805
- JP-A- 2008 128 796
- JP-A- 2019 032 212
- JP-A- 2020 178 456
- JP-A- 2020 178 456
- KR-A- 20190 067 872
- KR-A- 20190 067 872
- KR-A- 20220 017 216
- KR-A- 20220 017 216
- US-B2- 10 432 031

## Description

### [Technical Field]

Embodiments disclosed herein relate to a wearable electronic device including a circuit board assembly and a wireless charging assembly.

### [Background Art]

In line with the development of electronic, information, or communication technology, a variety of functions are being included in a single electronic device. As electronic devices are highly enhanced in performance and miniaturized, it is common to carry and use electronic devices, and portable electronic devices are provided in various forms. For example, a user may carry and use a plurality of portable electronic devices such as a smartphone, a tablet PC, a smart watch, wireless earphones, and/or smart glasses.

Wearable electronic devices having various forms, such as glasses or watches, are being disclosed so that the electronic devices can be worn on the body and used. For example, a wearable electronic device may provide biometric information of a user using sensors mounted on the body. For example, the wearable electronic device may include a sensor having a function capable of obtaining the biometric information and a variety of other information, as well as obtaining a user's electrocardiogram (ECG), respiration, electromyogram (EMG), electrooculogram (EOG), electroencephalogram (EEG), blood glucose, oxygen saturation (SpO2), photoplethysmography (PPG), or body temperature.

Such a wearable electronic device may include a battery for supplying power necessary for the operation of a display and other various electronic components and a module (e.g., a wireless charging module) for charging the battery, as well as a sensor for obtaining biometric information.

The above information may be provided as background technology for the purpose of assisting understanding of the disclosure of this document. No claim or determination is made as to whether any of the foregoing may be applied as prior art in connection with the disclosure of this document. Conventional devices are known from KR 2019 0067872 A and JP 2020 178456 A. KR 2022 0017216 A discloses a wearable electronic device comprising a housing, a circuit board assembly disposed inside the housing, and a coil assembly disposed around the circuit board assembly. The circuit board assembly comprises a first circuit board layer comprising a first conductive area on which at least one conductive pattern is formed and a first non-conductive area formed around the first conductive area. At least one sensor comprising a plurality of electric elements is disposed on the first circuit board layer. The first conductive area comprises an outer edge area disposed around each of the plurality of electric elements.

### [Detailed Description of the Invention]

### [Technical Solution]

A wearable electronic device according to the invention includes a housing, a circuit board assembly disposed inside the housing, and/or a coil assembly disposed around the circuit board assembly. The circuit board assembly includes a first circuit board layer and at least one sensor including a plurality of electric elements (e.g., photoelectric conversion elements). The first circuit board layer includes a first conductive area on which at least one conductive pattern is formed and a first non-conductive area formed around the first conductive area. The plurality of electric elements are disposed along a periphery of the first circuit board layer. The first conductive area includes an outer edge area disposed around each of the plurality of electric elements. The first non-conductive area includes at least one slit area disposed in the outer edge area.

### [Brief Description of Drawings]

The above-described or other aspects, configurations, and/or advantages of an embodiment of the disclosure will become more apparent through the following detailed description with reference to the accompanying drawings.
FIG. 1 is a block diagram of an electronic device in a network environment according to an embodiment disclosed in this document.
FIG. 2 is a front perspective view of a wearable electronic device according to an embodiment of the disclosure.
FIG. 3 is a rear perspective view of a wearable electronic device according to an embodiment of the disclosure.
FIG. 4 is an exploded perspective view illustrating a wearable electronic device according to an embodiment of the disclosure.
FIG. 5 is a perspective view of a wireless charging assembly and a circuit board assembly according to an embodiment of the disclosure.
FIG. 6 is a plan view of a first circuit board of a circuit board assembly according to an embodiment of the disclosure.
FIG. 7 is a plan view illustrating a surface current density of a first circuit board of a circuit board assembly according to an embodiment of the disclosure.
FIG. 8 is an enlarged view of a portion A in FIG. 7 according to an embodiment of the disclosure.
FIG. 9 is a plan view illustrating a surface current density of a first circuit board of a circuit board assembly according to an embodiment of the disclosure.
FIG. 10 is an enlarged view of a portion B in FIG. 9 according to an embodiment of the disclosure.
FIG. 11 is a plan view illustrating a surface current density of a first conductive area of a circuit board assembly and positions of vias thereof according to an embodiment of the disclosure.
FIG. 12 is an enlarged view of a portion C in FIG. 11 according to an embodiment of the disclosure.
FIG. 13 is a plan view illustrating a surface current density of a second conductive area and positions of vias thereof according to an embodiment of the disclosure.
FIG. 14 is an enlarged view of a portion D in FIG. 13 according to an embodiment of the disclosure.
FIG. 15 is a plan view illustrating a surface current density of a first conductive area from which some vias are removed in FIG. 11.
FIG. 16 is an enlarged view of a portion E in FIG. 15 according to an embodiment of the disclosure.
FIG. 17 is a plan view illustrating a surface current density of a second conductive area from which some vias are removed in FIG. 13.
FIG. 18 is an enlarged view of a portion F in FIG. 17 according to an embodiment of the disclosure.
FIG. 19 is a graph showing charging power and temperature depending on a charging time of a wireless charging assembly according to an embodiment of the disclosure.

Throughout the accompanying drawings, like reference numbers may be assigned to like components, configurations, and/or structures.

### [Mode for Carrying out the Invention]

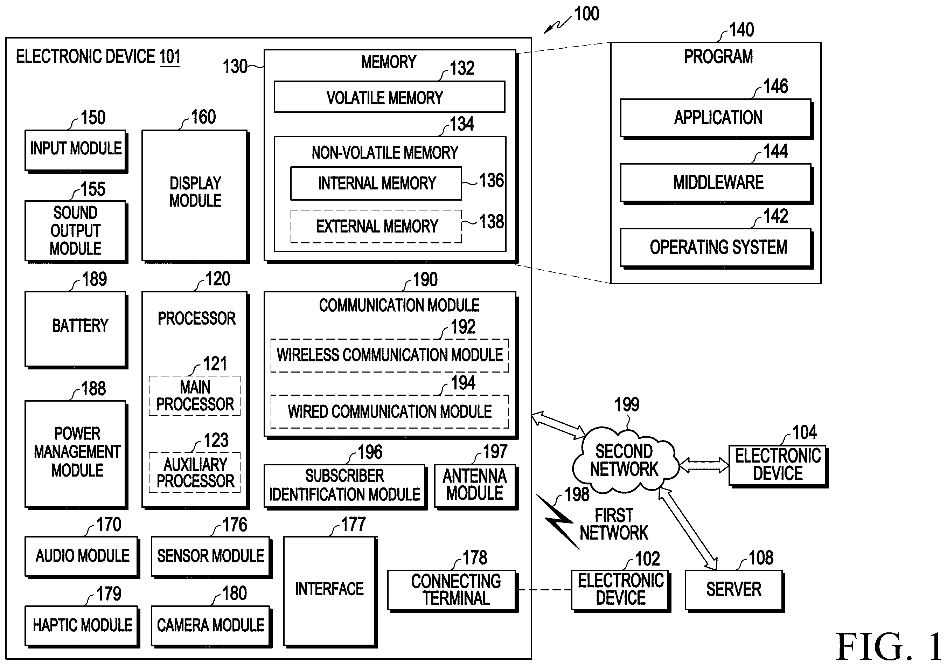

FIG. 1 is a block diagram illustrating an electronic device 101 in a network environment 100 according to embodiments.

Referring to FIG. 1, the electronic device or the wearable device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In embodiments, at least one of the components (e.g., the connecting terminal 178) may be omitted from the electronic device 101, or one or more other components may be added in the electronic device 101. In embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least a part of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least a part of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices , or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

In the following detailed description, a lengthwise direction, a widthwise direction, and/or a thickness direction of an electronic device may be referred to, and the lengthwise direction may be defined as a "Y-axis direction", the widthwise direction may be defined as an "X-axis direction", and/or the thickness direction may be defined as a "Z-axis direction". In an embodiment, "negative/positive (-/+)" directions may be expressed for the direction in which an element is directed, in addition to the orthogonal coordinate system illustrated in the drawing. For example, the front face of the electronic device or housing may be defined as "a surface facing in the +Z direction" and the rear surface thereof may be defined as "a surface facing in the -Z direction". In an embodiment, the side of the electronic device or housing may include an area facing in the +X direction, an area facing in the +Y direction, an area facing in the -X direction, and/or an area facing in the -Y direction. In another embodiment, the "X-axis direction" may indicate both the "-X direction" and the "+X direction". It should be noted that this is based on the orthogonal coordinate system described in the drawings for brevity of description and that the descriptions of these directions or elements are not limited to an embodiment disclosed in this document. For example, the aforementioned direction of the front or rear face may vary depending on the unfolded or folded state of the electronic device, and the aforementioned directions may be interpreted differently depending on the user's holding habit.

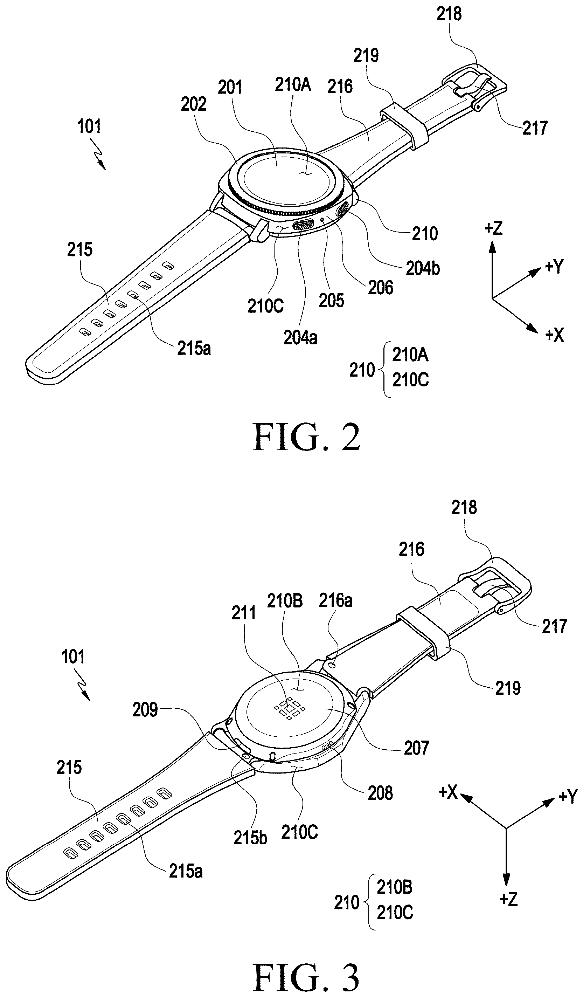

All or some of the configurations of the wearable electronic device 101 shown in FIGS. 2 to 4 may be the same as the configurations of the electronic device (or wearable electronic device) 101 in FIG. 1.

FIG. 2 is a front perspective view of a wearable electronic device according to an embodiment of the disclosure. FIG. 3 is a rear perspective view of a wearable electronic device in FIG. 2 according to an embodiment of the disclosure.

In the following detailed description, in FIGS. 2 to 4, the widthwise direction or lengthwise direction of a wearable electronic device 101 or housing 210 may be any one of the "X-axis direction" and the "Y-axis direction" of the illustrated orthogonal coordinate system. If it is necessary to distinguish the widthwise direction or the lengthwise direction, the directions of the orthogonal coordinate system shown in the drawing may be written together. In the orthogonal coordinate system in FIGS. 2 to 4, the "Z-axis direction" may indicate the thickness direction of the wearable electronic device 101 or housing 210. In an embodiment, the direction in which the front surface (e.g., the first surface 210A in FIG. 2) of the wearable electronic device 101 or housing 210 faces may be defined as a "first direction" or "+Z direction", and the direction in which the rear surface (e.g., the second surface 210B in FIG. 3) of the wearable electronic device 101 or housing 210 faces may be defined as a "second direction" or "-Z direction".

Referring to FIGS. 2 and 3, the wearable electronic device 101 according to an embodiment may include a housing 210 including a first surface (or front surface) 210A, a second surface (or rear surface) 210B, and a side surface 210C surrounding a space between the first surface 210A and the second surface 210B, and wearing members 215 and 216 connected to at least a part of the housing 210 and configured to cause the wearable electronic device 101 or the housing 210 to be worn on a user's body part (e.g., wrist, ankle, etc.). In another embodiment (not shown), the housing 210 may refer to a structure forming some of the first surface 210A, the second surface 210B, and the side surface 210C in FIG. 2. According to an embodiment, the first surface 210A may be formed by a front plate 201 (e.g., a glass plate or a polymer plate including various coating layers) that is substantially transparent at least in part. The second surface 210B may be formed by a substantially opaque rear plate 207. However, the aforementioned materials must not be construed as limiting and other materials may also be used. In an embodiment, in the case where the electronic device includes a first sensor module 211 disposed on the second surface 210B, the rear plate 207 may include an at least partially transparent area. The rear plate 207 may be formed of, for example, coated or tinted glass, ceramic, polymer, metal (e.g., aluminum, stainless steel (STS), or magnesium), or a combination of at least two of the above materials. The side surface 210C may be formed by a side bezel structure (or "side member") 206 coupled to the front plate 201 and/or the rear plate 207 and including a metal and/or a polymer. In an embodiment, the rear plate 207 and the side bezel structure 206 may be integrally formed and include the same material (e.g., a metal material such as aluminum). The wearing members 215 and 216 may be formed of various materials and have various shapes. Integral and plurality of unit links may be formed to be movable relative to each other by woven materials, leather, rubber, urethane, metal, ceramic, or a combination of at least two of the above materials.

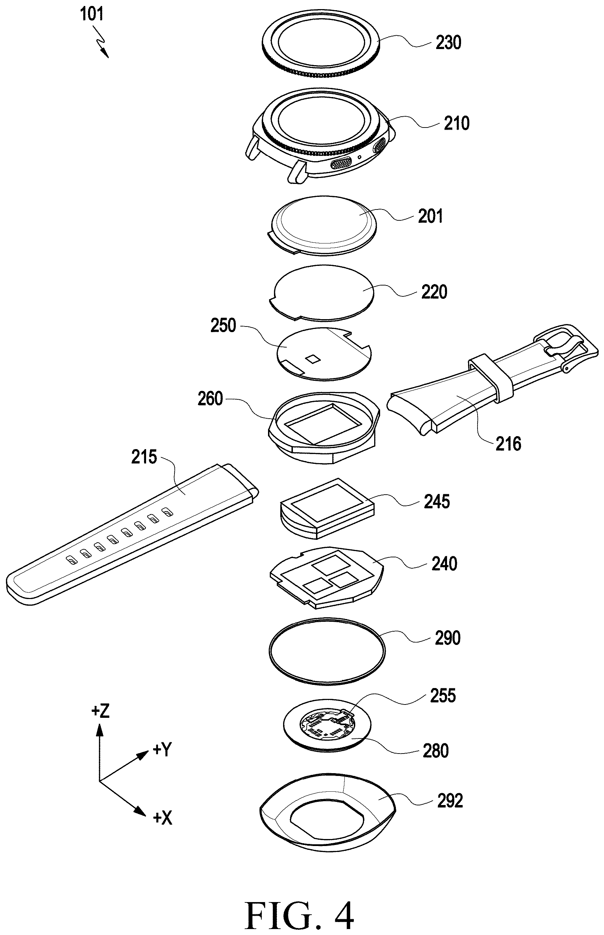

According to an embodiment, the wearable electronic device 101 may include at least one of a display 220 (see FIG. 4) (e.g., the display module 160 in FIG. 1), audio modules 205 and 208, a first sensor module 211 (e.g., the sensor module 176 in FIG. 1), key input devices 202, 204a, and 204b, and a connector hole 209. In an embodiment, the wearable electronic device 101 may exclude at least one (e.g., the key input devices 202, 204a, 204b, the connector hole 209, or the first sensor module 211) of the elements or further include other elements. For example, the wearable electronic device 101 may also include no key input devices at all.

The display (e.g., the display 220 in FIG. 4) may be exposed through, for example, most of the front plate 201. The display 220 may have a shape corresponding to the shape of the front plate 201 and may have various shapes such as a circle, an oval, or a polygon, e.g. a square. The display 220 may be coupled to or disposed adjacent to a touch sensing circuit, a pressure sensor capable of measuring the intensity (pressure) of a touch, and/or a fingerprint sensor.

The audio holes 205 and 208 may include a microphone hole 205 and a speaker hole 208. The microphone for obtaining external sound may be disposed inside the microphone hole 205, and according to an embodiment, a plurality of microphones may be disposed to detect the direction of sound. The speaker hole 208 may be used as an external speaker and a receiver for a call. According to an embodiment, a speaker (e.g., a piezo speaker) may be included without a speaker hole.

The sensor module (e.g., the sensor module 176 in FIG. 1) may generate an electrical signal or data value corresponding to an inner operation state of the wearable electronic device 101 or an external environmental state. In an embodiment, the sensor module may include a first sensor module 211 that is a biometric sensor (e.g., an HRM sensor) disposed on the second surface 210B of the housing 210. The wearable electronic device 101 may include a sensor module not shown, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor. The wearable electronic device 101 may also comprise at least one further sensor module.

The key input devices 202, 204a, and 204b may include a wheel key 202 disposed on the first surface 210A of the housing 210 to be rotatable in at least one direction, and/or side key buttons 204a and 204b disposed on the side surface 210C of the housing 210. The wheel key 202 may have a shape corresponding to the shape of the front plate 201. In another embodiment, the wearable electronic device 101 may exclude some or all of the above-mentioned key input devices 202, 204a, and 204b, and the excluded key input devices 202, 204a, and 204b may be implemented in the form of a soft key on the display 220, which may e.g. be a touch display. The connector hole 209 may receive a connector (e.g., a USB connector) for transmitting and receiving power and/or data to and from an external electronic device, and may include another connector hole (not shown) for receiving a connector for transmitting and receiving audio signals to and from an external electronic device. The wearable electronic device 101 may further include, for example, a connector cover (not shown) that covers at least a portion of the connector hole 209 and prevents external foreign substances from entering the connector hole.

The wearing members 215 and 216 may be detachably attached to at least a portion of the housing 210 using locking members 215b and 216a. The locking members 215b and 216a may include, for example, a fastening component such as a pogo pin, and according to an embodiment, may be replaced by protrusions or recesses formed on the wearing members 215 and 216. For example, the wearing members 215 and 216 may be coupled in a manner of engaging with the recesses or protrusions formed in the housing 210. The wearing members 215 and 216 may include one or more of a fixing member 217, a fixing member fastening hole 215a, a band guide member 218, and a band fixing ring 219.

The fixing member 217 may be configured to fix the housing 210 and the wearing members 215 and 216 to a user's body part (e.g., wrist, ankle, or the like). The fixing member fastening hole 215a may fix the housing 210 and the wearing members 215 and 216 to a user's body part to correspond to the fixing member 217. The band guide member 218 may be configured to limit the movement range of the fixing member 217 when the fixing member 217 is fastened to the fixing member fastening hole 215a, so that the wearing members 215 and 216 are tightly attached to a user's body part. The band fixing ring 219 may limit the movement range of the wearing members 215 and 216 in the state in which the fixing member 217 and the fixing member fastening hole 215a are fastened.

FIG. 4 is an exploded perspective view illustrating a wearable electronic device according to an embodiment of the disclosure.

Referring to FIG. 4, the wearable electronic device 101 may include a housing 210 (or side bezel structure) (e.g., the housing 210 in FIGS. 2 and 3), a wheel key 230, a front plate 201 (e.g., the front plate 201 in FIG. 2), a display 220 (e.g., the display module 160 in FIG. 1), a first antenna 250 (e.g., the antenna module 197 in FIG. 1), a second antenna (e.g., an antenna (e.g., the antenna module 197 in FIG. 1) included in the auxiliary circuit board 255), a support member 260 (e.g., a bracket), a battery 245 (e.g., the battery 189 in FIG. 1), a printed circuit board 240, a sealing member 290, a rear plate 292, and wearing members 215 and 216 (e.g., the wearing members 215 and 216 in FIGS. 2 and 3). At least one of the elements of the wearable electronic device 101 may be the same as or similar to at least one of the elements of the wearable electronic device 101 in FIGS. 2 or 3, and redundant descriptions thereof will be omitted below.

In an embodiment, the support member 260 may be disposed inside the wearable electronic device 101 to be connected to the housing 210 or integrally formed with the housing 210. The support member 260 may be formed of, for example, a metal material and/or a non-metal (e.g., polymer) material. The support member 260 may have the display 220 coupled to one surface thereof and the printed circuit board 240 coupled to the other surface thereof. The printed circuit board 240 may include a processor (e.g., the processor 120 in FIG. 1), a memory (e.g., the memory 130 in FIG. 1), and/or an interface (e.g., the interface 177 in FIG. 1), which are mounted thereto. The processor may include, for example, one or more of a central processing unit, an application processor, a graphics processing unit (GPU), an application processor, a sensor processor, or a communication processor.

The memory may include, for example, volatile memory or non-volatile memory. The interface may include, for example, a high-definition multimedia interface (HDMI), a universal serial bus (USB) interface, an SD card interface, and/or an audio interface. For example, the interface may electrically or physically connect the wearable electronic device 101 to an external wearable electronic device and include a USB connector, an SD card/MMC connector, or an audio connector.

The battery 245 is a device for supplying power to at least one element of the wearable electronic device 101, and may include, for example, a non-rechargeable primary battery, a rechargeable secondary battery, or a fuel cell. At least a portion of the battery 245 may be disposed, for example, on a substantially coplanar surface with the printed circuit board 240. The battery 245 may be integrally disposed inside the wearable electronic device 101 or disposed to be detachable from the wearable electronic device 101.

The first antenna 250 may be disposed between the display 220 and the support member 260. The first antenna 250 may include, for example, a near-field communication (NFC) antenna, a wireless charging antenna, and/or a magnetic secure transmission (MST) antenna. For example, the first antenna 250 may perform short-range communication with an external device, wirelessly transmit and receive power required for charging, and transmit a short-range communication signal or a magnetic-based signal including payment data. In another embodiment, an antenna structure may be formed by a part of the housing 210 and/or the support member 260 or a combination thereof.

The auxiliary circuit board 255 may be disposed between the printed circuit board 240 and the rear plate 292. The auxiliary circuit board 255 may include an antenna, for example, a near-field communication (NFC) antenna, a wireless charging antenna, and/or a magnetic secure transmission (MST) antenna. For example, the auxiliary circuit board 255 may perform short-range communication with an external device, wirelessly transmit and receive power required for charging, and transmit a short-range communication signal or a magnetic-based signal including payment data. In an embodiment, an antenna structure may be formed by a part of the housing 210 and/or the rear plate 292 or a combination thereof.

In an embodiment, in the case where the wearable electronic device 101 (e.g., the wearable electronic device 101 in FIGS. 2 and 3) includes a sensor module (e.g., the sensor module 176 in FIG. 1 or the first sensor module 211 in FIG. 3), a separate sensor circuit or sensor element may be disposed in the sensor circuit disposed on the auxiliary circuit board 255. The sensor circuit or sensor element may include, for example, a light-emitting element, a photoelectric conversion element, or an electrode pad.

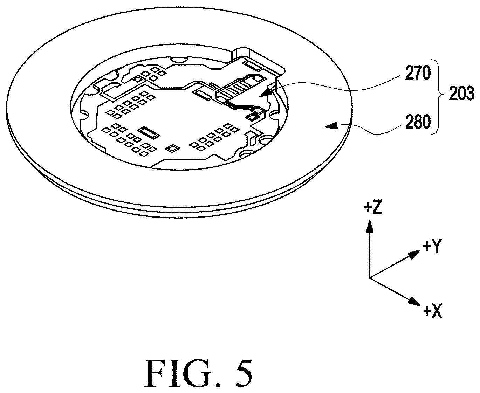

According to an embodiment, a coil assembly 280 (e.g., a wireless charging coil) may be disposed between the printed circuit board 240 and the rear plate 292. The coil assembly 280 may be electrically connected to the printed circuit board 240 and/or the auxiliary circuit board 255. For example, the coil assembly 280 may be disposed around the auxiliary circuit board 255. The coil assembly 280 may be a charging coil in which current is induced in response to a magnetic field of a wireless charging device disposed outside. In an embodiment, both the auxiliary circuit board 255 and the coil assembly 280 may constitute a wireless charging assembly (e.g., the wireless charging assembly 207 in FIG. 5). For example, the auxiliary circuit board 255 and the coil assembly 280 may be integrally formed.

The sealing member 290 may be positioned between the housing 210 and the rear plate 292. The sealing member 290 may be configured to prevent moisture and foreign matter from entering into a space surrounded by the housing 210 and the rear plate 292 from the outside.

The wearing members 215 and 216 may be connected to different areas of the housing 210 and disposed in a symmetrical shape.

The following embodiments will be described with reference to the electronic device 101 in FIGS. 1 to 4 described above, and the same reference numerals will be assigned to the elements capable of being easily understood through the above-described embodiments or omitted, and the detailed description thereof may also be omitted.

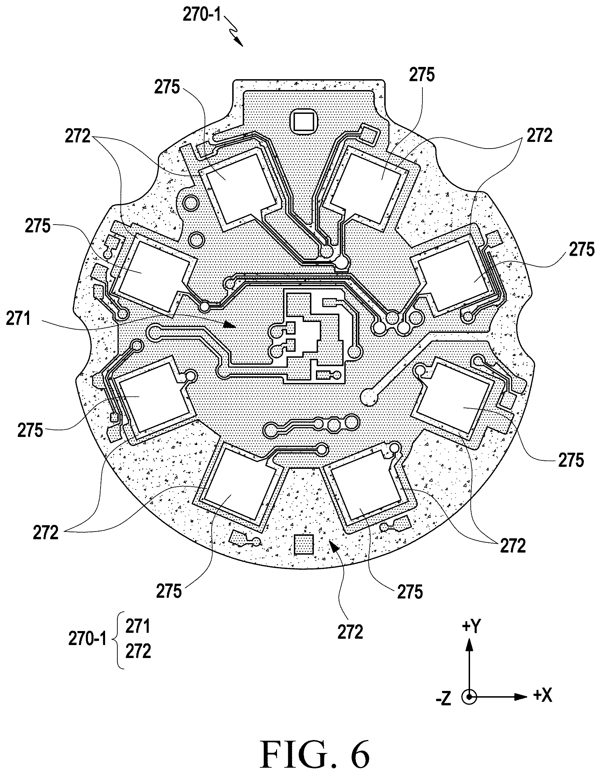

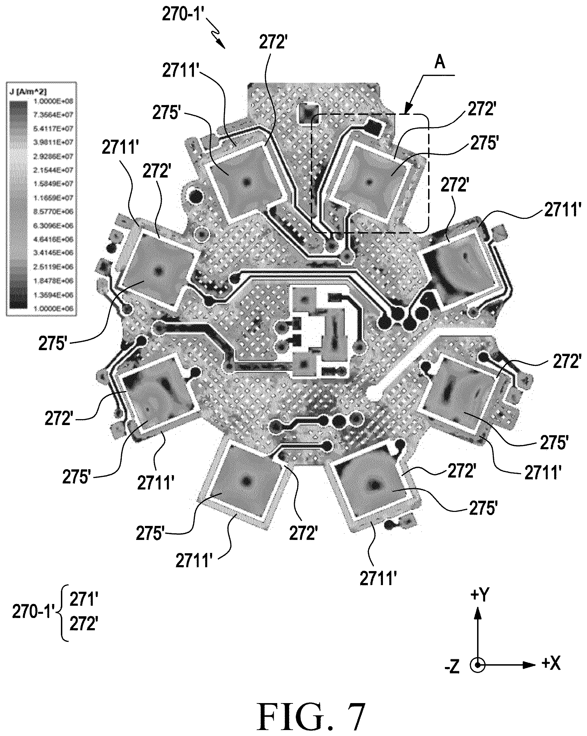

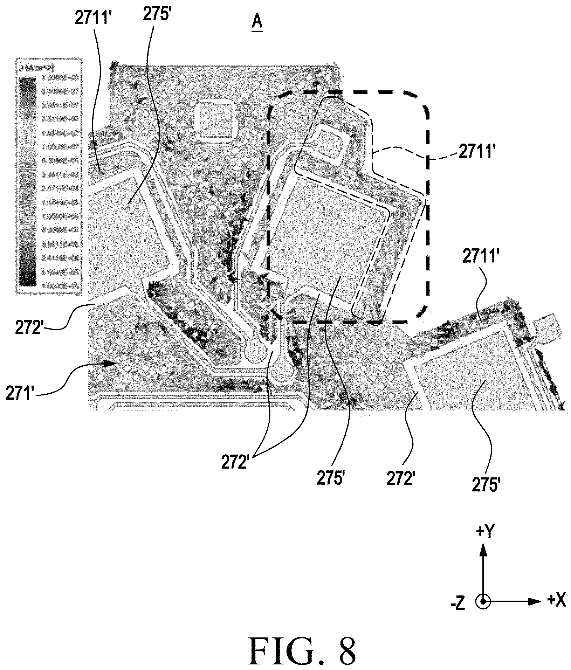

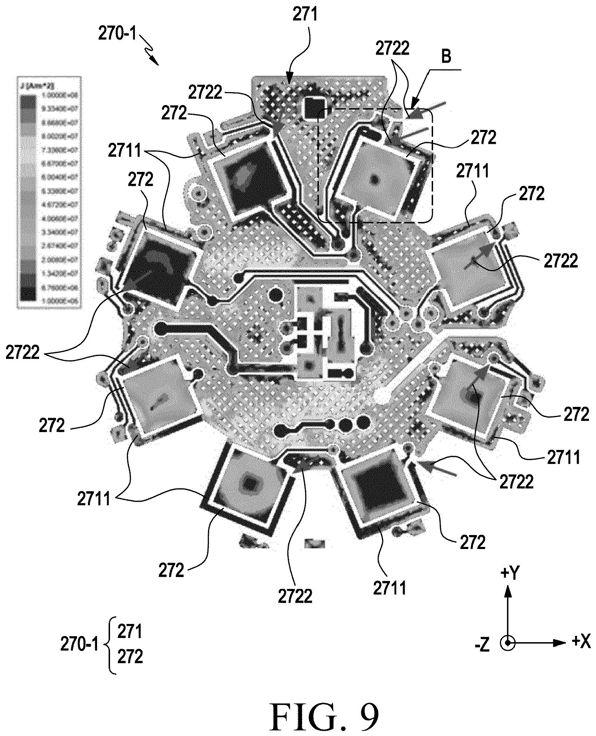

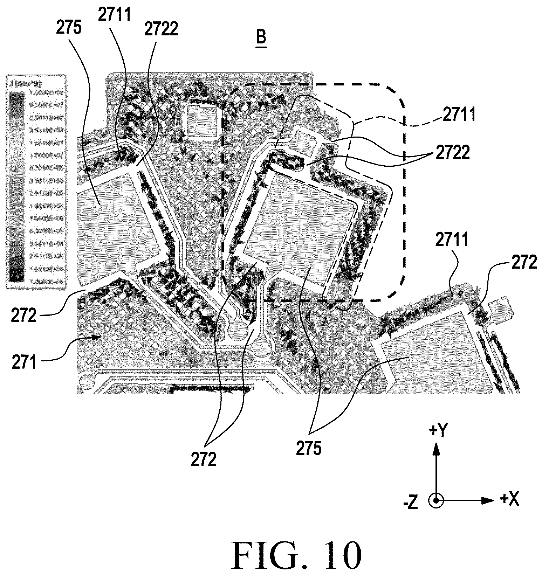

FIG. 5 is a perspective view of a wireless charging assembly and a circuit board assembly according to an embodiment of the disclosure. FIG. 6 is a plan view of a first circuit board layer of a circuit board assembly according to an embodiment of the disclosure. FIG. 7 is a plan view illustrating a surface current density of a first circuit board layer of a circuit board assembly according to an embodiment of the disclosure. FIG. 8 is an enlarged view of a portion A in FIG. 7 according to an embodiment of the disclosure. FIG. 9 is a plan view illustrating a surface current density of a first circuit board layer of a circuit board assembly according to an embodiment of the disclosure. FIG. 10 is an enlarged view of a portion B in FIG. 9 according to an embodiment of the disclosure.

Referring to FIG. 5, in an embodiment, a wearable electronic device 101 may include a wireless charging assembly 203. According to an embodiment, the wireless charging assembly 203 (e.g., 255 in FIG. 4) may include a coil assembly 280 and/or a circuit board assembly 270 (e.g., the auxiliary circuit board 255). For example, the wireless charging assembly 203 may further include a magnetic material (not shown) that helps align the wearable electronic device 101 and the wireless charging device. In an embodiment, the coil assembly 280 and/or the circuit board assembly 270 may be interposed between a bracket (e.g., the support member 260 in FIG. 4) and a rear plate (e.g., the rear plate 292 in FIG. 4). According to an embodiment, for example, the coil assembly 280 and the circuit board assembly 270 may be positioned on the same plane, and the circuit board assembly 270 may be arranged to be closer to the rear plate 292 than the coil assembly 280.

According to an embodiment, the coil assembly 280 may be electrically connected to the circuit board assembly 270 and/or the main circuit board (e.g., the printed circuit board 240 in FIG. 4). According to an embodiment, the coil assembly 280 may include a charging coil in which current is induced in response to a magnetic field of a wireless charging device disposed outside the wearable electronic device 101. For example, the charging coil of the coil assembly 280 may be a flat coil. For example, the wearable electronic device 101 may use the induced current generated by the coil assembly 280 as power or may charge a battery (e.g., the battery 245 in FIG. 4) therewith. In an embodiment, the wireless charging assembly 280 may be disposed to surround the circuit board assembly 270, and the circuit board assembly 270 may be spaced apart from the coil assembly 280.

In an embodiment, the circuit board assembly 270 may include a plurality of (e.g., four) circuit boards stacked in a thickness direction (e.g., the Z-axis direction) of the wearable electronic device 101 and a photoelectric conversion element 275 disposed on at least a part (e.g., the first circuit board layer 270-1) of the plurality of circuit boards. According to an embodiment, all or part of the structure of the circuit board assembly 270 may be the same as or similar to that of the auxiliary circuit board 255. For example, the wearable electronic device 101 may utilize the photoelectric conversion element 275 as a sensor (e.g., the sensor module 176 in FIG. 1 and/or the first sensor module 211 in FIG. 3) for detecting biometric information of the user. According to an embodiment (not shown), for example, the wearable electronic device 101 may further include a light-emitting element (e.g., an LED) (not shown) and may selectively combine the light-emitting elements (not shown) and/or the photoelectric conversion elements 275 and utilize the same as a sensor (e.g., the sensor module 176 in FIG. 1 and/or the first sensor module 211 in FIG. 3) for detecting biometric information (e.g., a heart rate (HRM or HRV)) of the user.

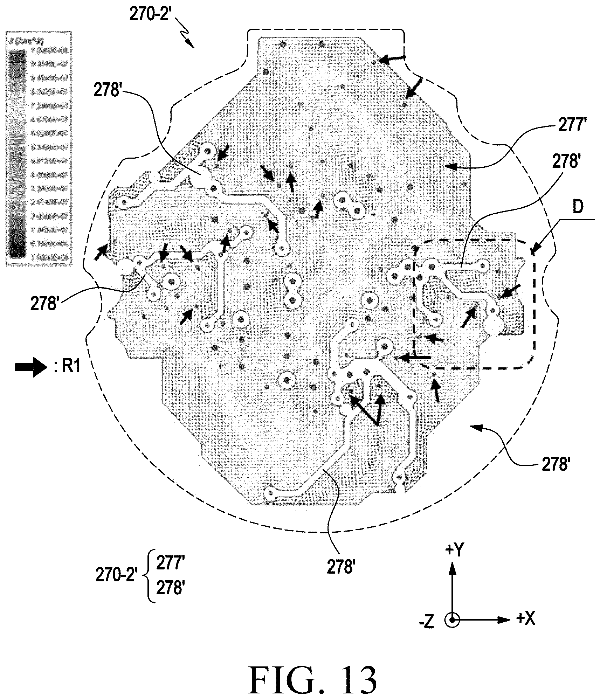

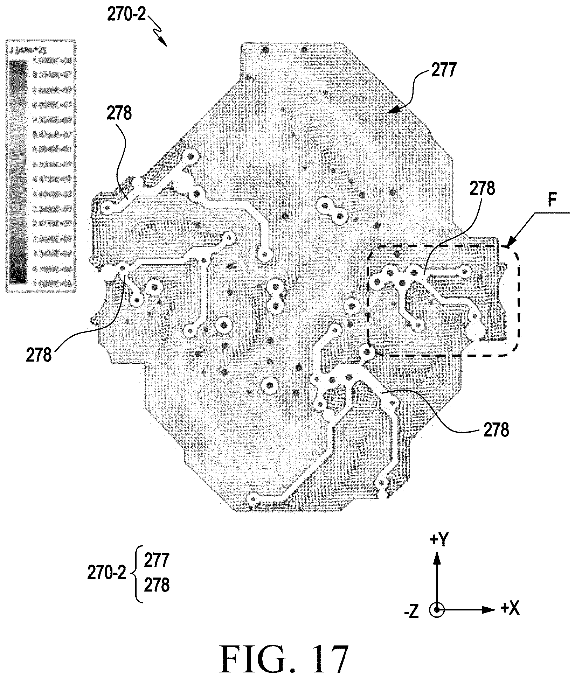

Referring to FIGS. 5 to 9, in an embodiment, the circuit board assembly 270 may include a circuit board (or printed circuit board) including at least one circuit board layer. In an embodiment, the circuit board assembly 270 may include a first circuit board layer 270-1 (e.g., the first circuit board layer 270-1 in FIGS. 6, 7, 9, 11, and 15) and/or a second circuit board layer 270-2 (e.g., the second circuit board layer 270-2 in FIGS. 13 and 17) disposed to overlap the first circuit board layer 270-1. According to an embodiment, a rear cover (not shown) may be disposed between the circuit board assembly 270 and the rear plate (e.g., the rear plate 292 in FIG. 4), and the first circuit board layer 270-1 may be disposed to substantially face one surface of the rear cover (not shown). For example, the second circuit board layer 270-2 may be stacked relative to the first circuit board layer 270-1 in a direction toward the front surface (e.g., the first surface 210A in FIG. 2) of the wearable electronic device or in the "+Z direction". However, the disclosure is not limited to two circuit board layer and at least one further circuit board layer may be foreseen.

In the disclosure, an "outer area" of the circuit board may refer to an edge area of the circuit board on a plane on which the circuit board is placed, and an "inner area" thereof may refer to a central area surrounded by edges.

Referring to FIG. 6, in the present invention, the first circuit board layer 270-1 includes a first conductive area 271 and a first non-conductive area 272 formed on one surface (e.g., the -Z-directional surface). The first conductive area 271 includes at least one conductive pattern. According to an embodiment, the first conductive area 271 may correspond to the ground pattern of the first circuit board layer 270-1. For example, various electrical/electronic components (e.g., optical components) and/or wires (e.g., signal or power wires) electrically connected to the first conductive area 271 may be disposed in the first circuit board layer 270-1. According to an embodiment, an outer portion of the first conductive area 271 may be adjacent to an outermost line of the first circuit board layer 270-1. For example, the first non-conductive area 272 may include areas in which a conductor such as metal (e.g., a conductive area, electric/electronic components, and/or wires) is not disposed in the first circuit board layer 270-1. However, in an embodiment (not shown), the first conductive area 271 may also be used as a meaning encompassing a conductive pattern such as an antenna pattern, as well as the ground pattern of the first circuit board layer 270-1, and/or at least a part of signal or power wires.

According to an embodiment, a plurality of photoelectric conversion elements 275 (e.g., photodiodes) may be disposed on one surface (e.g., the -Z-directional surface) of the first circuit board layer 270-1. According to an embodiment, the photoelectric conversion elements 275 may be spaced apart from each other along an outer (edge) area of the first circuit board layer 270-1. In other words, the photoelectric conversion elements 275 may surround a center of the first circuit board layer 270-1, e.g. in an equidistant manner. For example, the photoelectric conversion element 275 may be electrically connected to a processor (e.g., the processor 120 in FIG. 1) disposed in other electric/electronic components and/or the printed circuit board (e.g., the printed circuit board 240 in FIG. 4) or the circuit board assembly 270 (e.g., the auxiliary circuit board 255 in FIG. 4) of the first circuit board layer 270-1. In an embodiment (not shown), a plurality of light-emitting elements (e.g., LEDs) (not shown) may be disposed on one surface (e.g., the -Z-directional surface) of the first circuit board layer 270-1. For example, the light-emitting element (not shown) may emit a near-infrared ray, an infrared ray, and/or green light, and the photoelectric conversion element 275 may receive or detect light in a specified wavelength band. For example, the light-emitting element (not shown) may be disposed to be closer to the inner (central) area of the first circuit board layer 270-1 than the photoelectric conversion element 275.

In an embodiment, the rear plate (e.g., at least a portion of the rear plate 292 in FIG. 4) may come into contact with the user's body while the wearable electronic device 101 is worn on the user's body, and if a request or command for detecting biometric information, the processor (e.g., the processor 120 in FIG. 1) may emit light using the light-emitting element (not shown) and detect the light reflected by the user's body using the photoelectric conversion element 275. The term "reflected light" may refer to the light that is reflected by the user's body in an area substantially in contact with the rear plate. Based on the emitted light and/or detected light (or reflected light), the wearable electronic device 101 and/or the processor (e.g., the processor 120 in FIG. 1) may detect or determine the user's biometric information. According to an embodiment, the rear plate (e.g., the rear plate 292 in FIG. 4) may be configured to at least partially transmit the light emitted from the light-emitting element (not shown) disposed on the circuit board assembly 270 to the outside of the wearable electronic device 101 and/or the light received by the photoelectric conversion element 275 from the outside. Although not shown in the disclosure, the wearable electronic device 101 may further include an electrode pad or a pressure sensor exposed to the outside of the rear plate (e.g., the rear plate 292 in FIG. 4). In this case, the circuit board assembly 270 may be electrically connected to the electrode pad or the pressure sensor. For example, the electrode pad or pressure sensor may come into direct contact with the user's body and may be used to detect the user's biometric information (e.g., electrocardiogram, blood pressure, and/or heart rate).

According to an embodiment, the wearable electronic device 101 may use a combination of the photoelectric conversion element 275 and/or the light-emitting element (not shown) as a sensor (e.g., the sensor module 176 in FIG. 1 and/or the third sensor module 211 in FIG. 3), thereby collecting the user's biometric information. For example, the photoelectric conversion element 275 may collect raw data for measuring biometric information such as blood pressure, blood flow, heart rate (HRM or HRV), body temperature, respiratory rate, oxygen saturation (SpO2), heart-rate sound detection, blood sugar, girth, height, weight, body fat, calorie consumption, brain waves, voice, skin resistance, electromyogram, and/or electrocardiogram of the user. For example, the wearable electronic device 101 may collect and process the raw data, thereby producing biometric information. As an example, the wearable electronic device 101 may collect pulse data using a combination of the photoelectric conversion element 275 and/or the light-emitting element (not shown) as a heart rate variability (HRV) and/or heart rate monitor (HRM) sensor. For example, the wearable electronic device 101 may process collected pulse data and provide biometric information such as average heart rate, heart rate distribution, and/or blood vessel aging.

In the present invention, the first conductive area 271 includes an outer edge area 2711. According to an embodiment, the outer edge area 2711 may be disposed outside the photoelectric conversion element 275 disposed along the edge of the first circuit board layer 270-1. According to an embodiment, a loop of current flowing through the outermost part of the conductive area may be formed in at least a portion of the outer edge area 2711. According to an embodiment, the outer edge area 2711 may be spaced apart from the photoelectric conversion element 275, and a portion of the first non-conductive area 272 may exist therebetween. For example, the outer edge area 2711 may surround at least a portion of the edge of the photoelectric conversion element 275 facing the outside of the first circuit board layer 270-1. The outer edge area 2711 may be a conductive pattern disposed to surround the photoelectric conversion element 275. For example, the outer edge area 2711 may be disposed along one side or several (e.g., two or three) sides of the photoelectric conversion element 275. According to an embodiment, the outer edge area 2711 may be a strip-shaped conductive pattern and have a width equal to or less than a first specified value. According to an embodiment, the first specified value may be about 100µm to about 500µm, for example, about 300µm.

Hereinafter, a description according to an embodiment of the disclosure will be made by comparing the surface current density of a first circuit board layer 270-1' before forming a slit area 2722 (see FIGS. 7 and 8) in the first conductive area 271 (e.g., the outer edge area 2711) with the surface current density of the first circuit board layer 270-1 after forming the slit area 2722 therein (see FIGS. 9 and 10) with reference to FIGS. 9 to 10. Here, the "surface current density" may be a density of current including eddy current flowing through a conductor (e.g., a conductive area, an electrical/electronic component, and/or wires) such as metal disposed on one surface of the circuit board assembly 270.

Referring to FIGS. 7 and 8, a relatively high surface current density may be measured in some areas where eddy currents are concentrated in the first conductive area 271' of the first circuit board layer 270-1'. Here, the eddy current may be generated by a magnetic field (hereinafter an "external magnetic field") of an external wireless charging device that induces current in a charging coil (not shown) of the coil assembly (e.g., the coil assembly 280 in FIG. 5). If the density of the eddy current increases, ohmic loss of the circuit board assembly 270 may increase, and heating temperature may increase due to a reduction in wireless charging efficiency caused by ohmic loss. For example, the circuit board assembly 270 may have an increased influence of an electromagnetic field by a charging coil (not shown) from the central area to the outer area thereof. For example, the eddy current may have a relatively high density in at least a portion of the conductive area (e.g., the first conductive area 271') disposed on the outer area of the first circuit board layer 270-1' compared to that in the central area thereof. Referring to FIG. 8, according to an embodiment, among the outer areas of the circuit board assembly 270, an outer edge area 2711' of the first conductive area 271' in the first circuit board layer 270-1' may have a greater surface current density than that in other areas because it has a small width.

Referring to FIGS. 9 and 10, according to the present invention, the first circuit board layer 270-1 includes at least one slit area 2722 to block local current flow in the first conductive area 271. According to the invention, the slit area 2722 is included in the first non-conductive area 272.

According to an embodiment, the slit area 2722 may be disposed in an area in which a higher or highest surface current density is measured in the first conductive area 271. For example, the slit area 2722 may be formed by removing a portion of the first conductive area 271 in consideration of positions of electrical/electronic components and/or signal or power wires. In an embodiment, the slit area 2722 in FIG. 9 may be formed in a dense area in which the surface current density is about 10 times or more the lowest surface current density in another area in the first circuit board layer 270-1' or the first conductive area 271' in FIG. 7. For example, the minimum value of the surface current density in the first circuit board layer 270-1' may be about 1.0000E+06, e.g. 0.9000E+06 to 1.1000E+06, and the maximum value thereof may be about 1.0000E+08, e.g. 0.9000E+08 to 1.1000E+08. Referring to FIG. 10, the slit area 2722, for example, may be formed to cross a portion (e.g., the outer edge area 2711) of the first conductive area 271 in the widthwise direction thereof. The widthwise direction may refer to a direction to cross (e.g., orthogonal to) the direction (or the lengthwise direction) in which at least a portion of the outer edge area 2711 extends. For example, the slit area 2722 may be formed to block the flow of current from a portion of the first conductive area 271 (e.g., the outer edge area 2711) disposed on one side to a portion disposed on the other side. Therefore, by forming the slit area 2722, it is possible to alleviate concentration of eddy currents on the first conductive area 271 (e.g., the outer edge area 2711) around the slit area 2722, thereby reducing the surface current density and ohmic loss.

According to an experimental example, the ohmic loss of the first circuit board layer (e.g., the first circuit board layer 270-1' in FIGS. 7 and 8) may be about 0.1579 Watts (W) before a slit area 2722 is formed, and the ohmic loss may be reduced by 10 % or more in the case where one slit area 2722 is formed in the outer edge area 2711, and the ohmic loss may be reduced by double or more in the case where a plurality of (e.g., nine) slit areas 2722 is formed in the outer edge area 2711 according to the embodiment in FIG. 9. According to an experimental example, the ohmic loss of the first circuit board layer 270-1 may be about 0.1579 Watts (W) in the case where a slit area 2722 is not formed (e.g., in the case of the first circuit board layer 270-1' in FIGS. 7 and 8), may be about 0.1345 Watts (W) in the case where one slit area 2722 is formed in the outer edge area 2711, and may be about 0.0584 Watts (W) in the case where a plurality of (e.g., nine) slit areas 2722 is formed in the outer edge area 2711 according to the embodiment in FIG. 9.

According to an embodiment, the slit area 2722 may be disposed in an area having a relatively high (or highest) surface current density, as well as in the outer edge area 2711, and may also be positioned in the central area of the first conductive area 271. For example, the central area is an area disposed inside the outer edge area 2711 in the first conductive area 271 and may include an area surrounded by the photoelectric conversion element 275. For example, the first conductive area 271 may have a narrow width in a partial area thereof due to arrangement of wires and electrical/electronic components. For example, the slit area 2722 may be disposed in an area having a relatively high (or highest) eddy current or surface current density due to a relatively narrow area of the first conductive area 271 and/or electromagnetic interference from nearby electric/electronic components. For example, the width of the first conductive area 271 in which the slit area 2722 is formed may be less than a first specified value. According to an embodiment, the first specified value may be about 100µm to about 500µm, for example, about 300µm. However, the description made with reference to FIGS. 5 to 10 is only an example, and the structure of the first circuit board layer 270-1, for example, the shapes and arrangement of the first conductive area 271 and the photoelectric conversion element 275 are not limited. In addition, the number and positions of the slit areas 2722 according to an embodiment are not limited and may vary depending on the structure of the first circuit board layer 270-1 and the surface current density according thereto. Moreover, also the numbers mentioned for the specified value are illustrative only and any value in e.g. steps of 5µm between 100µm and 500µm may be used.

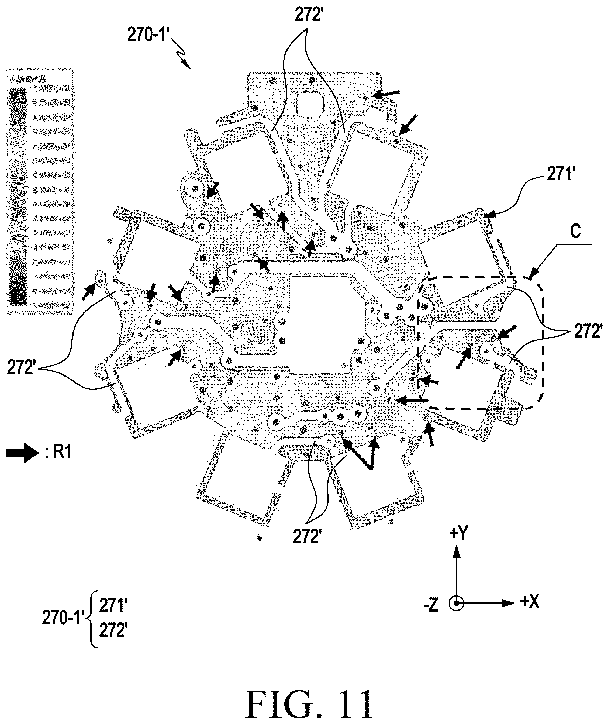

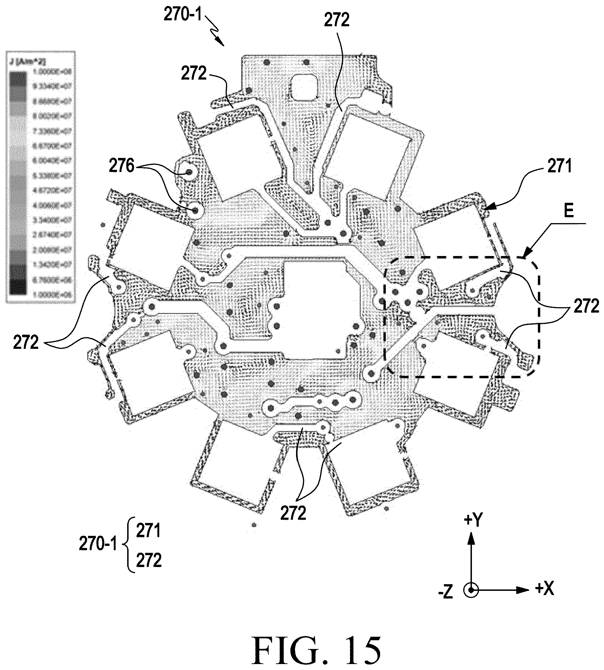

Hereinafter, an embodiment of the disclosure will be described by comparing FIGS. 11 to 14 showing the surface current density of a first conductive area 271' or a second conductive area 277' before removing vias 276' with FIGS. 15 to 18 showing the surface current density of a first conductive area 271 or a second conductive area 277 after removing vias 276.

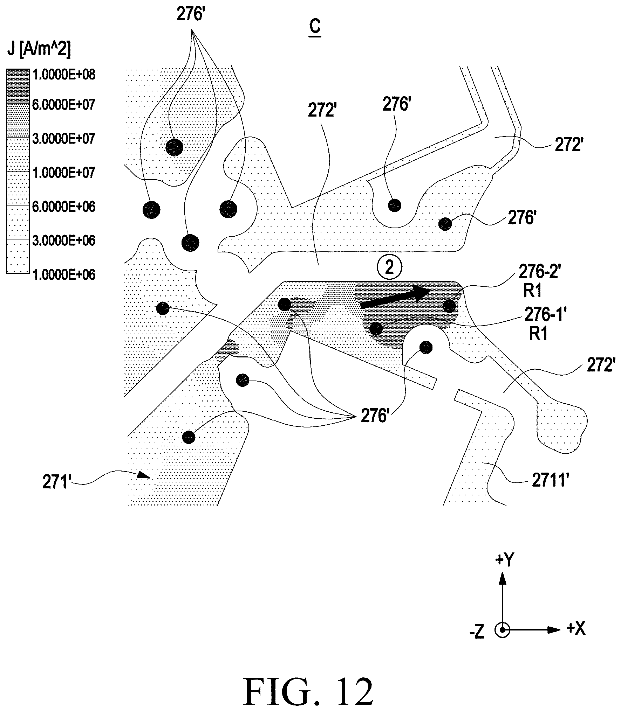

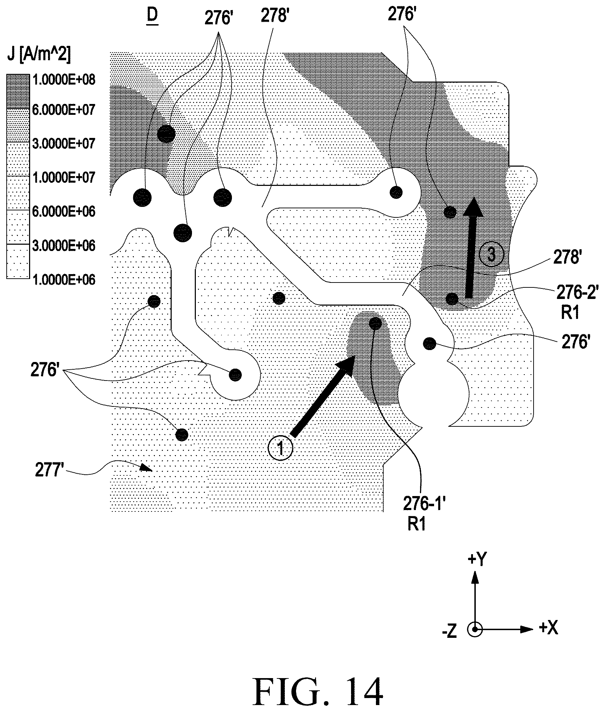

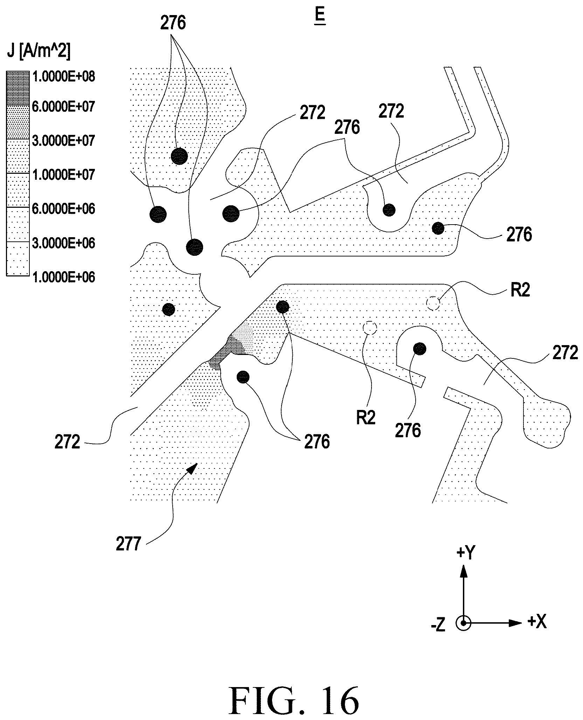

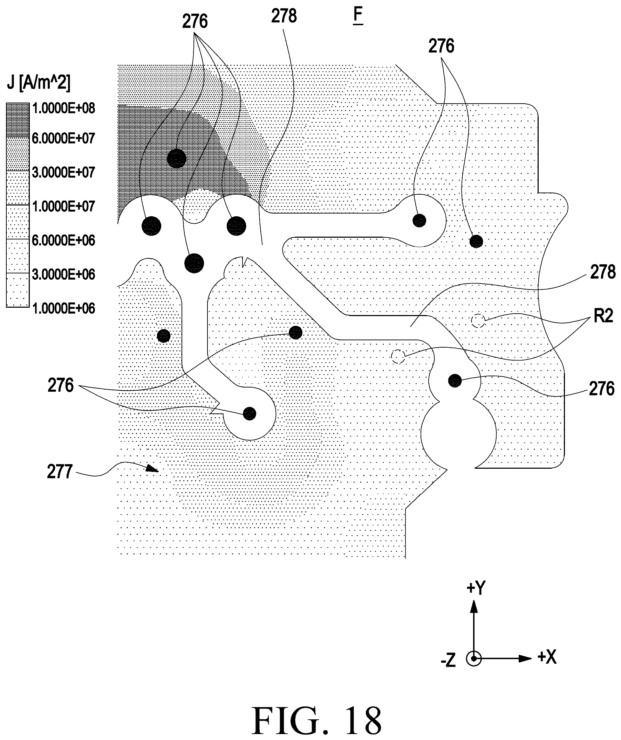

FIG. 11 is a plan view illustrating a surface current density of a first conductive area of a circuit board assembly and positions of vias thereof according to an embodiment of the disclosure. FIG. 12 is an enlarged view of a portion C in FIG. 11 according to an embodiment of the disclosure. FIG. 13 is a plan view illustrating a surface current density of a second conductive area and positions of vias thereof according to an embodiment of the disclosure. FIG. 14 is an enlarged view of a portion D in FIG. 13 according to an embodiment of the disclosure. FIG. 15 is a plan view illustrating a surface current density of a first conductive area from which some vias are removed in FIG. 11. FIG. 16 is an enlarged view of a portion E in FIG. 15 according to an embodiment of the disclosure. FIG. 17 is a plan view illustrating a surface current density of a second conductive area from which some vias are removed in FIG. 13. FIG. 18 is an enlarged view of a portion F in FIG. 17 according to an embodiment of the disclosure.

A first circuit board layer 270-1' in FIGS. 11, 12, 15, and 16 may include the slit area 2722 described above with reference to FIGS. 6 to 10. The first circuit board layer 270-1' in FIGS. 11 and 12 and the first circuit board layer 270-1 in FIGS. 15 and 16 may refer to the first circuit board layer 270-1' in FIGS. 6, 9 and 10.

FIGS. 11 to 18, unlike FIGS. 7 to 10, may primarily show, for example, the surface current density of the first conductive area 271 or 271' or the second conductive area 277 or 277', excluding the photoelectric conversion element 275 or 275' and/or wires.

The first circuit board layer 270-1' in FIGS. 11 and 12 and the second circuit board layer 270-2' in FIGS. 15 and 16 may respectively indicate the first circuit board layer 270-1' and the second circuit board layer 270-2' before removing (or "before changing") some of vias 276', based on measured values of the surface current densities according to embodiments to be described later. The first circuit board layer 270-1 in FIGS. 13 and 14 and the second circuit board layer 270-2 in FIGS. 17 and 18 may respectively indicate the first circuit board layer 270-1 and the second circuit board layer 270-2 after removing (or "after changing") some of vias 276' disposed between the first circuit board layer 270-1' and the second circuit board layer 270-2' before change, based on measured values of the surface current densities according to embodiments to be described later.

Referring to FIGS. 15 to 18, in an embodiment, the circuit board assembly 270 may include a plurality of circuit boards and/or a plurality of conductive vias 276 and 276' for electrically connecting the circuit boards. According to an embodiment, the circuit board assembly 270 before or after change may include the first circuit board layer 270-1 or 270-1' and the second circuit board layer 270-2 or 270-2' stacked on one surface (e.g., the -Z-directional surface) of the first circuit board layer 270-1 or 270-1'. According to an embodiment, at least one via 276 or 276' may be disposed between the first circuit board layer 270-1 or 270-1' and the second circuit board layer 270-2 or 270-2'.

Referring to FIGS. 15 to 18, according to an embodiment, the second circuit board layer 270-2 or 270-2' may include a second conductive area 277 or 277' and a second non-conductive area 278 or 278'. For example, the second conductive area 277 or 277' may include at least one conductive pattern. According to an embodiment, the second conductive area 277 may correspond to the ground pattern of the second circuit board layer 270-2 or 270-2'. For example, various electric/electronic components and/or wires (e.g., signal or power wires) electrically connected to the second conductive area 277 or 277' may be disposed in the second circuit board layer 270-2 or 270-2'. According to an embodiment, an outer edge of the conductive area may be adjacent to and spaced apart from an outer edge of the second circuit board layer 270-2 or 270-2'. For example, the second non-conductive area 278 or 278' may include areas where a conductor such as metal (e.g., a conductive area, electric/electronic components, and/or wires) is not disposed in the second circuit board layer 270-2 or 270-2'. However, in an embodiment (not shown), the second conductive areas 277 and 277' may also be used as a meaning encompassing a conductive pattern such as an antenna pattern, as well as the ground pattern of the second circuit board layer 270-2 and 270-2', and/or at least a part of signal or power wires.

According to an embodiment, the at least one via 276 or 276' of the circuit board assembly 270 may electrically connect the first conductive area 271 or 271' of the first circuit board layer 270-1 or 270-1' and the second conductive area 277 or 277' of the second circuit board layer 270-2 or 270-2'. For example, the surface current (e.g., eddy current) of the first conductive area 271 or 271' may flow to the second conductive area 277 or 277' through the via 276 or 276', and vice versa.

Referring to FIGS. 11 to 14, in an embodiment, an arrow R1 may indicate positions of vias 276' to be removed. Referring to FIGS. 16 and 18, in an embodiment, an arrow R2 may indicate positions corresponding to the positions R1 of the vias 276' to be removed. For example, referring to FIGS. 11 to 14, the positions of the vias 276' to be removed (indicated by the arrow R1) may fall within an area where the surface current density is relatively high (or highest) on the first circuit board layer 270-1' and/or the second circuit board layer 270-2'. For example, a high density current may flow to the second conductive area 277' of the second circuit board layer 270-2' through the via 276' disposed in the first conductive area 271' of the first circuit board layer 270-1'. On the other hand, a high density current may flow to the first conductive area 271' of the first circuit board layer 270-1' through the via 276' disposed in the second conductive area 277' of the second circuit board layer 270-2'.

According to an embodiment of the disclosure, the surface current density may be reduced by removing the vias 276' disposed in the portion where the surface current density is measured to be relatively high (or highest) in the first conductive area 271' and/or the second conductive area 277'. However, according to an embodiment (not shown), some of the vias 276' disposed in the portion where the surface current density is measured to be relatively high (or highest) in the first conductive area 271' and/or the second conductive area 277' may be moved to another portion where the surface current density (or eddy current) is measured to be lower. Accordingly, it is possible to suppress the concentration of eddy current generated in portions of the first conductive area 271' and/or the second conductive area 277', and an increase in ohmic loss and heat generation according thereto.

As an example, the current in the area where the surface current density is measured to be high in the second circuit board layer 270-2' in FIG. 14 may flow in the direction of arrow ① to enter the first circuit board layer 270-1' through an adjacent first via 276-1', flow in the direction of arrow ② of the first circuit board layer 270-1' in FIG. 12 to re-enter the second circuit board layer 270-2' through a second via 276-2', and then flow in the direction of the arrow ③ in FIG. 14. Referring to FIGS. 16 and 18, it is possible to block the flow of current with a high density through the first via 276-1' and the second via 276-2' by removing the vias 276-1' and 276-2'. Accordingly, the surface current densities of the area of the first circuit board layer 270-1' and the area of the second circuit board layer 270-2' around the first via 276-2' and the second via 276-2' may be reduced by removing the first via 276-2' and the second via 276-2'.

However, the description made with reference to FIGS. 11 to 14 is only an example, and the structures of the first circuit board layer 270-1' and/or the second circuit board layer 270-2', for example, the shapes and arrangement of the first conductive area 271', the second conductive area 277', and/or the photoelectric conversion element 275' are not limited. In addition, the position of the via 276' to be removed according to an embodiment is not limited and may be configured and changed depending on, for example, the structure of the first circuit board layer 270-1' and the surface current density.

According to an embodiment, comparing FIGS. 11 to 14 with FIGS. 15 to 18, it can be seen that the surface current density is reduced in the area including the portion of the first conductive area 271' and/or the second conductive area 277' where the via 276' is removed or in the area adjacent thereto. The first circuit board layers 270-1 and 270-1' in FIGS. 11, 12, 15, and 16 may include the slit area 2722 described above with reference to FIGS. 6 to 10. Hereinafter, according to an embodiment of the disclosure described above, a description will be made to a reduction in heat generation of the circuit board assembly 270 and/or the wireless charging assembly 280 (see FIG. 5) and the improvement in the charging performance by comparing the case where the slit area 2722 is formed on the first circuit board 270-1 of the circuit board assembly 270 (see FIGS. 9, 10, and 15 to 18) and where a plurality of vias 276 is removed (see FIGS. 15 to 18) with the circuit board assembly 270 before change (see FIGS. 7 and 8).

Table 1 below shows measured values of ohmic losses of each circuit board of the circuit board assembly 270 and the entirety thereof according to an embodiment. According to an embodiment, the circuit board assembly 270 may include a circuit board layer 270-1 or 270-1', a second circuit board layer 270-2 or 270-2', a third circuit board (not shown), and a fourth circuit board (not shown), which are sequentially stacked in a direction in which the front surface of the wearable electronic device 101 (e.g., the first surface 210A in FIG. 2) faces or in the "+Z direction". According to an embodiment, referring to Table 1, it can be seen that ohmic loss is reduced in the entire circuit board assembly 270 and each of the first circuit board layer 270-1 or 270-1', and the second circuit board layer 270-2 or 270-2', the third circuit board (not shown), and the fourth circuit board (not shown). For example, the overall ohmic loss of the circuit board assembly 270 may be reduced by more than half, for example, about 61.7%. That is, according to an embodiment of the disclosure, it may be understood that the surface current density and ohmic loss are reduced in the entire circuit board assembly 270 and each circuit board, and that heat generation is suppressed.

**[Table 1]**

| Ohmic loss (W) | Circuit board assembly 270 | First circuit board layer 270-1 or 270-1' | Second circuit board layer 270-2 or 270-2' | Third layer | Fourth layer |
|---|---|---|---|---|---|
| Before improvement | 0.259 | 0.029 | 0.103 | 0.063 | 0.065 |
| After improvement | 0.099 | 0.011 | 0.047 | 0.014 | 0.027 |

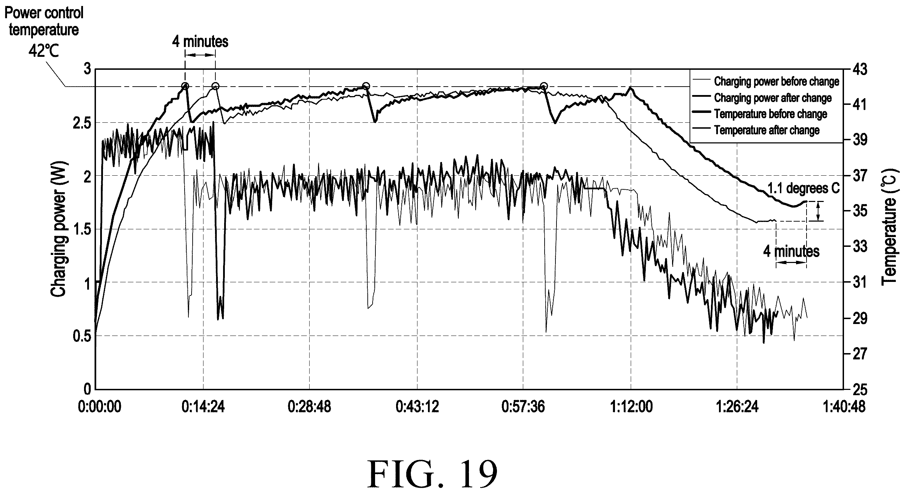

FIG. 19 is a graph showing charging power and temperature depending on a charging time using a wireless charging assembly 203 according to an embodiment of the disclosure. As will be described later, according to an embodiment of the disclosure, the time for a battery (e.g., the battery 245 in FIG. 4) to be fully charged may be shortened and heat generation may be suppressed during wireless charging using a wireless charging assembly (e.g., the wireless charging assembly 203 in FIG. 5). In FIG. 19 and the following description, the circuit board assembly 270 "before change" (see FIGS. 7 and 8) may correspond to a comparison group, and the circuit board assembly 270 "after change" (see FIGS. 15 to 18) may correspond to an experimental group and refer to the circuit board assembly 270 including the slit area 2722 in the first circuit board layer 270-1, from which some vias 276' are removed, according to an embodiment of the disclosure.

According to an embodiment, the wearable electronic device 101 may include at least one temperature measurement device (e.g., a thermistor) for measuring the internal temperature of the circuit board assembly 270 and/or the wearable electronic device 101. The device may be disposed on a bracket (e.g., the support member 260 in FIG. 4) supporting the circuit board assembly 270 and/or the coil assembly 280. For example, the wearable electronic device 101 may control charging such that the internal temperature of the circuit board assembly 270 and/or the wearable electronic device 101 remains in an appropriate temperature range during wireless charging using the internal temperature of the wearable electronic device 101 (hereinafter "measured internal device temperature") measured using the at least one temperature measurement device. For example, the wearable electronic device 101 may be configured to temporarily stop wireless charging, if the internal device temperature reaches a power control temperature (e.g., about 42 degrees C), until the internal device temperature is restored to a recovery temperature (e.g., about 40 degrees C).

According to an embodiment, during wireless charging using the coil assembly 280, a rate of rise in the internal temperature of the wearable electronic device 101 (hereinafter "measured internal device temperature") measured using at least one temperature measurement device after change may be reduced, compared the case before change. The time for the measured internal device temperature to initially reach the power control temperature (or "first power control entry time") may be delayed. According to an embodiment, the number of times of entering power control (or "the number of power control entries") may be reduced by half or more when the battery is fully charged once after change, compared to that before change. According to an embodiment, the time for the battery to be fully charged (or "full charge time") may be shortened after change compared to before change. According to an embodiment, the maximum value of the internal temperature of the wearable electronic device 101 at the time of full charge (or "temperature at full charge") may be reduced after change compared to before change. For example, a change in internal temperature of the wearable electronic device 101 may be similar to a change in temperature of the circuit board assembly 270. Although not shown in Table 2 or FIG. 19, the highest temperature of the circuit board assembly 270 during wireless charging for 10 minutes (e.g., under to conditions of 3.9V and 550mA) is about 39.70 degrees C before change and is about 36.50 degrees C after change, so that the temperature may be reduced by 3 degrees C or more from that before change.

Referring to FIG. 19 and Table 2 below, according to an experimental example, the time to initially reach the power control temperature (or "first power control entry time") may be delayed by about 4 minutes or more, and the number of power control entries may be reduced by about 2 or more. According to an experimental example, the full charge time may be reduced by about 4 minutes or more, and the temperature when fully charged may be reduced by about 1.1 degrees C or more.

**[Table 2]**

| | Before change | After change | Amount of change |
|---|---|---|---|
| First power control entry time | 12 minutes | 16 minutes | Delayed by 4 minutes |
| Number of power control entries | 3 times | One time | Reduced by 2 times |
| Full charge time | 96 minutes | 92 minutes | Reduced by 4 minutes |
| Temperature at full charge | 35.5 degrees C | 34.4 degrees C | 1.1 degrees C |

Table 3 below shows resistance values of a charging coil (not shown) of the coil assembly 280 and the simulation results of Q-factors between the case where the circuit board assembly 270 is changed (of after change) and the case before the change according to an embodiment of the disclosure. Here, the first conductive area 271 after change may correspond to a mesh-shaped ground pattern. Referring to Table 3, it can be identified that the resistance value of the charging coil (not shown) may be reduced after change and that the Q-factor thereof increases (e.g., by about 26%).

**[Table 3]**

| Characteristics of charging coil | | Ls (uH) | Rs (Ω) | Q | ΔQ |
|---|---|---|---|---|---|
| Experiment examples | Before change | 13.68 | 0.56 | 15.3 | |
| | After change | 13.78 | 0.45 | 19.4 | 26% |

According to an embodiment, the resistance of the charging coil (not shown) may decrease to reduce heat generation of the coil assembly 280, thereby increasing wireless charging efficiency. For example, the wireless charging efficiency may increase by about 2.5% to about 4.6%.

The wearable electronic device may have an eddy current that is generated by the influence of an external electromagnetic field in the conductive area (e.g., a ground pattern) of the circuit board assembly where a sensor for obtaining biometric information is disposed. For example, the circuit board assembly may be disposed in an empty space generally at the center of a charging coil (e.g., a flat coil) of a wireless charging assembly. In this case, the density of eddy current may be concentrated in the outer area of the circuit board assembly closest to the charging coil. When the eddy current increases, the ohmic loss of the circuit board assembly may increase, charging efficiency may deteriorate, and heat generation of the circuit board assembly and charging coil due to wireless charging may intensify.

An embodiment of the disclosure may provide a wearable electronic device (e.g., the wearable electronic device 101 in FIGS. 2 to 4), including a circuit board assembly (e.g., the circuit board assembly 270 in FIG. 5), capable of alleviating eddy current concentration and reducing ohmic loss of the entire circuit board assembly 270 by configuring the circuit board assembly 270 such that a slit area (e.g., the slit area 2722 in FIGS. 9 and 10) is formed by removing a portion of an area (e.g., the outer edge area 2711' in FIG. 8) having a relatively high surface current density due to concentration of eddy current in a conductive area (e.g., a ground pattern) (e.g., the first conductive area 271 in FIG. 6 and/or FIG. 9) of the circuit board assembly 270, thereby blocking a high-density current flow across the slit area 2722 and changing the current flow.

An embodiment of the disclosure may provide a wearable electronic device 101, including a plurality of circuit boards of the circuit board assembly 270, capable of alleviating eddy current concentration and reducing ohmic loss of the entire circuit board assembly 270 by configuring the circuit board assembly 270 in a manner of removing some of conductive vias (e.g., the vias 276 in FIG. 16) disposed in an area having a relatively high surface current density due to concentration of eddy current in each conductive area (e.g., a ground pattern) (e.g., the first conductive area 271 in FIG. 6 and/or FIG. 9) of two circuit board layers (e.g., the first circuit board layer 270-1 in FIG. 15 and the second circuit board layer 270-2 in FIG. 17) connected by the vias 276 or moving the same to another area. A wearable electronic device 101 according to the present invention includes a housing 110 or 210, a circuit board assembly 270 disposed inside the housing, and a coil assembly 280 disposed around the circuit board assembly. The circuit board assembly includes a first circuit board layer 270-1 and at least one sensor including a plurality of electric elements (e.g., photoelectric conversion elements) 275. The first circuit board layer includes a first conductive area 271 on which at least one conductive pattern is formed and a first non-conductive area 272 formed around the first conductive area. The plurality of electric elements is disposed along a periphery of the first circuit board layer. The first conductive area includes an outer edge area 2711 disposed around each of the plurality of electric elements. The first non-conductive area includes at least one slit area 2722 disposed in the outer edge area.

According to an embodiment, at least a part of a plurality of (e.g., two or three) portions of the outer edge area, which contact with the slit area, may be separated (e.g., physically separated) from each other by the slit area.

According to an embodiment, the first non-conductive area may include at least one slit area 2722 in the remaining area of the first conductive area, which does not overlap the outer edge area. For example, although not shown in the drawing, at least one slit area 2722 disposed in the remaining area may refer to the slit area 2722 positioned in the central area of the first conductive area 271, for example, an area of the first conductive area surrounded by the electric elements 275. At least a part of a plurality of portions of the remaining area, which contact with the slit area, may be separated (e.g., physically separated) from each other by the slit area.

According to an embodiment, the outer edge area may have a width at least partially equal to or less than a first specified value and extend along at least a portion of each perimeter of the plurality of electric elements.

According to an embodiment, the first specified value may be 100µm to 500µm.

According to an embodiment, the plurality of electric elements may be disposed to be spaced apart from each other along the periphery of the first circuit board layer.

According to an embodiment, at least a portion of the outer edge area may be disposed between the periphery of the first circuit board layer and at least one of the plurality of electric elements.

According to an embodiment, at least a part of the plurality of electric elements may include a photoelectric conversion element.

According to an embodiment, at least a part of the at least one conductive pattern of the first conductive area may be at least a part of a ground area disposed on the first circuit board layer.

According to an embodiment, the circuit board assembly may include a second circuit board layer 270-2 stacked on the first circuit board layer and at least one conductive via 276. According to an embodiment, the via may be disposed between the first circuit board layer and the second circuit board layer and electrically connect the first circuit board layer and the second circuit board layer.

According to an embodiment, the plurality of electric elements may be disposed on a first surface of the first circuit board layer. The second circuit board layer may be disposed in a direction in which a second surface of the first circuit board layer faces, which is opposite the first surface of the first circuit board layer, with respect to the first circuit board layer.

According to an embodiment, the second circuit board layer may include a second conductive area 277 on which at least one conductive pattern is formed and a second non-conductive area 278 formed around the second conductive area. According to an embodiment, the at least one via may be electrically connected to a part of the first conductive area and a part of the second conductive area, respectively.

According to an embodiment, at least a part of the at least one conductive pattern of the second conductive area may be at least a part of a ground area disposed on the second circuit board layer.

According to an embodiment, the coil assembly may include at least one charging coil spaced apart from the circuit board assembly. According to an embodiment, the charging coil may be configured to generate an induced current in response to an electromagnetic field generated from the outside of the wearable electronic device.

According to an embodiment, the wearable electronic device may include a battery disposed inside the housing and a wireless charging circuit electrically connected to the battery. According to an embodiment, the wireless charging circuit may be configured to charge the battery using an induced current generated in the charging coil. A wearable electronic device 101 according to an embodiment of the disclosure includes a housing 110 or 210, a circuit board assembly 270 disposed inside the housing, and a coil assembly 280 disposed around the circuit board assembly. The circuit board assembly includes a first circuit board layer 270-1 and at least one sensor. The first circuit board layer includes a first conductive area 271 on which at least one conductive pattern is formed and a first non-conductive area 272 formed around the first conductive area. The sensor includes a plurality of electric elements 275 disposed along the periphery of the first circuit board layer. The first conductive area includes an outer edge area 2711 extending along at least a portion of each periphery of the plurality of electric elements. The first non-conductive area includes at least one slit area 2722 disposed in the outer edge area. At least a part of a plurality of (e.g., two or three) portions of the outer edge area, which contact with the respective slit areas, may be separated (e.g., physically separated) by the slit area.

According to an embodiment, the first non-conductive area may include at least one slit area 2722 disposed in the remaining area of the first conductive area, which does not overlap the outer edge area. For example, although not shown in the drawing, at least one slit area 2722 disposed in the remaining area may refer to the slit area 2722 positioned in the central area of the first conductive area 271, for example, an area of the first conductive area surrounded by the electric elements 275. At least a part of a plurality of portions of the remaining area, which contact with the slit area, may be separated (e.g., physically separated) from each other by the slit area.

According to an embodiment, the outer edge area may have a width at least partially equal to or less than a first specified value and extends along at least a portion of each perimeter of the plurality of electric elements. The first specified value may be 100µm to 500µm.

According to an embodiment, the circuit board assembly may include a second circuit board layer 270-2 stacked on the first circuit board layer and/or at least one conductive via 276. According to an embodiment, the via may be disposed between the first circuit board layer and the second circuit board layer and electrically connect the first circuit board layer and the second circuit board layer.

According to an embodiment, the second circuit board layer may include a second conductive area 277 on which at least one conductive pattern is formed and a second non-conductive area 278 formed around the second conductive area. According to an embodiment, the at least one via may be electrically connected to a part of the first conductive area and a part of the second conductive area, respectively.

The following description of the accompanying drawings may be provided to facilitate a comprehensive understanding of various implementations of the disclosure defined by the claims. Although the specific embodiments disclosed in the following description contain various specific details to aid understanding, they are considered as one of an embodiment. Accordingly, it is obvious to those skilled in the art that various changes and modifications of various implementations described in this document can be made without departing from the scope of the disclosure. In addition, descriptions of well-known functions and configurations may be omitted for clarity and conciseness.

The terms and words used in the above description and claims are not limited to their reference meanings and may be used to clearly and consistently describe an embodiment disclosed herein. Accordingly, it will be obvious to those skilled in the art that the following descriptions of various implementations of the disclosure are provided for explanatory purposes only, instead of limiting the scope of the disclosure and the disclosures corresponding thereto.

It should be understood that singular forms such as "a", "an", and "the" include plural meanings, unless the context clearly dictates otherwise. Thus, for example, an "element surface" may have a meaning including one or more of the surfaces of the element.

The electronic device according to embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that embodiments of the present disclosure and the terms used therein are not intended to limit the technological features set forth herein to particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," *"coupled to, " "connected with,* " or "connected to" another element (e.g., a second element), it means that the element may be coupled with the other element directly (e.g., wiredly), wirelessly, or via a third element.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program) including one or more instructions that are stored in a storage medium (e.g., internal memory or external memory) that is readable by a machine (e.g., the wearable electronic device). For example, a processor (e.g., the processor) of the machine (e.g., the wearable electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components may be omitted, or one or more other components may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A wearable electronic device (101) comprising:
a housing (110; 210);
a circuit board assembly (270) disposed inside the housing (110; 210); and
a coil assembly (280) disposed around the circuit board assembly (270),
wherein the circuit board assembly (270) comprises:
a first circuit board layer (270-1) comprising a first conductive area (271) on which at least one conductive pattern is formed and a first non-conductive area (272) formed around the first conductive area (271); and
at least one sensor comprising a plurality of electric elements (275) disposed along a periphery of the first circuit board layer (270-1),
wherein the first conductive area (271) comprises an outer edge area (2711) disposed around each of the plurality of electric elements (275), and
wherein the first non-conductive area (272) comprises at least one slit area (2722) disposed in the outer edge area (2711).

2. The wearable electronic device (101) of claim 1, wherein at least a part of a plurality of portions of the outer edge area (2711), which contact with the respective slit areas (2722), are separated by the slit area (2722).

3. The wearable electronic device (101) of claim 1 or 2, wherein the first non-conductive area (272) comprises the at least one slit area (2722) in the remaining areas of the first conductive area (271), which do not overlap the outer edge area (2711), and
wherein at least a part of a plurality of portions of the remaining areas, which contact with the respective slit areas (2722), are separated by the slit area (2722).

4. The wearable electronic device (101) of one of claims 1 to 3, wherein the outer edge area (2711) has a width equal to or less than a first specified value and extends along at least a portion of each perimeter of the plurality of electric elements (275).

5. The wearable electronic device (101) of claim 4, wherein the first specified value is 100µm to 500µm.

6. The wearable electronic device (101) of one of claims 1 to 5, wherein the plurality of electric elements (275) are disposed to be spaced apart from each other along the periphery of the first circuit board layer (270-1).

7. The wearable electronic device (101) of one of claims 1 to 6, wherein at least a portion of the outer edge area (2711) is disposed between the periphery of the first circuit board layer (270-1) and at least one of the plurality of electric elements (275).

8. The wearable electronic device (101) of one of claims 1 to 7,
wherein at least a part of the at least one conductive pattern of the first conductive area (271) is at least a part of a ground area disposed on the first circuit board layer (270-1).

9. The wearable electronic device (101) of one of claims 1 to 8, wherein the circuit board assembly (270) further comprises:
a second circuit board layer (270-2) disposed on one surface of the first circuit board layer (270-1); and
at least one conductive via (276) disposed between the first circuit board layer (270-1) and the second circuit board layer (270-2) and configured to electrically connect the first circuit board layer (270-1) and the second circuit board layer (270-2).

10. The wearable electronic device (101) of claim 9, wherein the plurality of electric elements (275) are disposed on a first surface (210A) of the first circuit board layer (270-1), and
wherein the second circuit board layer (270-2) is disposed in a direction in which a second surface (210B) of the first circuit board layer (270-1) faces, which is opposite the first surface (210A) of the first circuit board layer (270-1), with respect to the first circuit board layer (270-1).

11. The wearable electronic device (101) of claim 9 or 10, wherein the second circuit board layer (270-2) comprises a second conductive area (277) on which at least one conductive pattern is formed and a second non-conductive area (278) formed around the second conductive area (277), and
wherein the at least one via (276) is electrically connected to a part of the first conductive area (271) and a part of the second conductive area (277), respectively.

12. The wearable electronic device (101) of claim 11, wherein at least a part of the at least one conductive pattern of the second conductive area (277) is at least a part of a ground area disposed on the second circuit board layer (270-2).

13. The wearable electronic device (101) of one of claims 1 to 12, wherein the coil assembly (280) comprises at least one charging coil spaced apart from the circuit board assembly (270) and configured to generate an induced current in response to an electromagnetic field generated from the outside of the wearable electronic device (101).

14. The wearable electronic device (101) of claim 13, further comprising:
a battery (189) disposed inside the housing (110; 210); and
a wireless charging circuit electrically connected to the battery (189) and configured to charge the battery (189) using an induced current generated in the charging coil.

15. The wearable electronic device (101) of one of claims 1 to 14, wherein the outer edge area (2711) extends along at least a portion of each periphery of the plurality of electric elements (275), and/or
wherein at least a part of a plurality of portions of the outer edge area (2711), which contact with the respective slit areas (2722), are separated by the slit area (2722).

## Patentansprüche

1. Tragbare elektronische Vorrichtung (101), umfassend:
ein Gehäuse (110; 210);
eine Leiterplattenbaugruppe (270), die innerhalb des Gehäuses (110; 210) angeordnet ist; und
eine Spulenbaugruppe (280), die um die Leiterplattenbaugruppe (270) herum angeordnet ist,
wobei die Leiterplattenbaugruppe (270) umfasst:
eine erste Leiterplattenschicht (270-1), die einen ersten leitfähigen Bereich (271), auf dem mindestens ein leitfähiges Muster ausgebildet ist, und einen ersten nichtleitfähigen Bereich (272), der um den ersten leitfähigen Bereich (271) herum ausgebildet ist, umfasst; und
mindestens einen Sensor, der eine Vielzahl von elektrischen Elementen (275) umfasst, die entlang eines Umfangs der ersten Leiterplattenschicht (270-1) angeordnet sind,
wobei der erste leitfähige Bereich (271) einen äußeren Randbereich (2711) umfasst, der um jedes der Vielzahl von elektrischen Elementen (275) herum angeordnet ist, und
wobei der erste nichtleitfähige Bereich (272) mindestens einen Schlitzbereich (2722) umfasst, der in dem äußeren Randbereich (2711) angeordnet ist.

2. Tragbare elektronische Vorrichtung (101) nach Anspruch 1, wobei mindestens ein Teil einer Vielzahl von Abschnitten des äußeren Randbereichs (2711), die mit den jeweiligen Schlitzbereichen (2722) in Kontakt stehen, durch den Schlitzbereich (2722) getrennt sind.

3. Tragbare elektronische Vorrichtung (101) nach Anspruch 1 oder 2, wobei der erste nichtleitfähige Bereich (272) den mindestens einen Schlitzbereich (2722) in den verbleibenden Bereichen des ersten leitfähigen Bereichs (271) umfasst, die den äußeren Randbereich (2711) nicht überlappen, und
wobei mindestens ein Teil einer Vielzahl von Abschnitten der verbleibenden Bereiche, die mit den jeweiligen Schlitzbereichen (2722) in Kontakt stehen, durch den Schlitzbereich (2722) getrennt sind.

4. Tragbare elektronische Vorrichtung (101) nach einem der Ansprüche 1 bis 3, wobei der äußere Randbereich (2711) eine Breite aufweist, die gleich oder kleiner als ein erster vorgegebener Wert ist, und sich entlang mindestens eines Abschnitts jedes Umfangs der Vielzahl von elektrischen Elementen (275) erstreckt.

5. Tragbare elektronische Vorrichtung (101) nach Anspruch 4, wobei der erste vorgegebene Wert 100 µm bis 500 µm beträgt.

6. Tragbare elektronische Vorrichtung (101) nach einem der Ansprüche 1 bis 5, wobei die Vielzahl von elektrischen Elementen (275) entlang des Umfangs der ersten Leiterplattenschicht (270-1) voneinander beabstandet angeordnet sind.

7. Tragbare elektronische Vorrichtung (101) nach einem der Ansprüche 1 bis 6, wobei mindestens ein Abschnitt des äußeren Randbereichs (2711) zwischen dem Umfang der ersten Leiterplattenschicht (270-1) und mindestens einem der Vielzahl von elektrischen Elementen (275) angeordnet ist.

8. Tragbare elektronische Vorrichtung (101) nach einem der Ansprüche 1 bis 7,
wobei mindestens ein Teil des mindestens einen leitfähigen Musters des ersten leitfähigen Bereichs (271) mindestens ein Teil eines Massebereichs ist, der auf der ersten Leiterplattenschicht (270-1) angeordnet ist.

9. Tragbare elektronische Vorrichtung (101) nach einem der Ansprüche 1 bis 8, wobei die Leiterplattenbaugruppe (270) ferner umfasst:
eine zweite Leiterplattenschicht (270-2), die auf einer Oberfläche der ersten Leiterplattenschicht (270-1) angeordnet ist; und
mindestens ein leitfähiges Durchgangsloch (276), die zwischen der ersten Leiterplattenschicht (270-1) und der zweiten Leiterplattenschicht (270-2) angeordnet und dazu konfiguriert ist, die erste Leiterplattenschicht (270-1) und die zweite Leiterplattenschicht (270-2) elektrisch zu verbinden.

10. Tragbare elektronische Vorrichtung (101) nach Anspruch 9, wobei die Vielzahl von elektrischen Elementen (275) auf einer ersten Oberfläche (210A) der ersten Leiterplattenschicht (270-1) angeordnet sind, und
wobei die zweite Leiterplattenschicht (270-2) in einer Richtung angeordnet ist, in die eine zweite Oberfläche (210B) der ersten Leiterplattenschicht (270-1) weist, die der ersten Oberfläche (210A) der ersten Leiterplattenschicht (270-1) gegenüberliegt, bezogen auf die erste Leiterplattenschicht (270-1).

11. Tragbare elektronische Vorrichtung (101) nach Anspruch 9 oder 10, wobei die zweite Leiterplattenschicht (270-2) einen zweiten leitfähigen Bereich (277), auf dem mindestens ein leitfähiges Muster ausgebildet ist, und einen zweiten nichtleitfähigen Bereich (278), der um den zweiten leitfähigen Bereich (277) herum ausgebildet ist, umfasst, und
wobei das mindestens eine Durchgangsloch (276) elektrisch mit einem Teil des ersten leitfähigen Bereichs (271) bzw. einem Teil des zweiten leitfähigen Bereichs (277) verbunden ist.

12. Tragbare elektronische Vorrichtung (101) nach Anspruch 11, wobei mindestens ein Teil des mindestens einen leitfähigen Musters des zweiten leitfähigen Bereichs (277) mindestens ein Teil eines Massebereichs ist, der auf der zweiten Leiterplattenschicht (270-2) angeordnet ist.

13. Tragbare elektronische Vorrichtung (101) nach einem der Ansprüche 1 bis 12, wobei die Spulenbaugruppe (280) mindestens eine Ladespule umfasst, die von der Leiterplattenbaugruppe (270) beabstandet ist und dazu konfiguriert ist, in Reaktion auf ein von außerhalb der tragbaren elektronischen Vorrichtung (101) erzeugtes elektromagnetisches Feld einen induzierten Strom zu erzeugen.

14. Tragbare elektronische Vorrichtung (101) nach Anspruch 13, ferner umfassend:
eine Batterie (189), die innerhalb des Gehäuses (110; 210) angeordnet ist; und
eine drahtlose Ladeschaltung, die elektrisch mit der Batterie (189) verbunden und dazu konfiguriert ist, die Batterie (189) unter Verwendung eines in der Ladespule erzeugten induzierten Stroms zu laden.

15. Tragbare elektronische Vorrichtung (101) nach einem der Ansprüche 1 bis 14, wobei sich der äußere Randbereich (2711) entlang mindestens eines Abschnitts jedes Umfangs der Vielzahl von elektrischen Elementen (275) erstreckt, und/oder
wobei mindestens ein Teil einer Vielzahl von Abschnitten des äußeren Randbereichs (2711), die mit den jeweiligen Schlitzbereichen (2722) in Kontakt stehen, durch den Schlitzbereich (2722) getrennt sind.

## Revendications

1. Dispositif électronique habitronique (101) comprenant :
un boîtier (110 ; 210) ;
un ensemble de carte de circuit imprimé (270) disposé à l'intérieur du boîtier (110 ; 210) ; et
un ensemble de bobine (280) disposé autour de l'ensemble de carte de circuit imprimé (270),
dans lequel l'ensemble de carte de circuit imprimé (270) comprend :
une première couche de carte de circuit imprimé (270-1) comprenant une première zone conductrice (271) sur laquelle est formé au moins un motif conducteur et une première zone non conductrice (272) formée autour de la première zone conductrice (271) ; et
au moins un capteur comprenant une pluralité d'éléments électriques (275) disposés le long d'un périmètre de la première couche de carte de circuit imprimé (270-1),
dans lequel la première zone conductrice (271) comprend une zone de bord extérieur (2711) disposée autour de chacun de la pluralité d'éléments électriques (275), et
dans lequel la première zone non conductrice (272) comprend au moins une zone fendue (2722) disposée dans la zone de bord extérieur (2711).

2. Dispositif électronique habitronique (101) selon la revendication 1, dans lequel au moins une partie d'une pluralité de portions de la zone de bord extérieur (2711), qui sont en contact avec les zone fendues (2722) respectives, est séparée par la zone fendue (2722).

3. Dispositif électronique habitronique (101) selon la revendication 1 ou 2, dans lequel la première zone non conductrice (272) comprend au moins une zone fendue (2722) dans les zones restantes de la première zone conductrice (271), qui ne chevauchent pas la zone de bord extérieur (2711), et
dans lequel au moins une partie d'une pluralité de portions de la zone restantes, qui sont en contact avec les zone fendues (2722) respectives, est séparée par la zone fendue (2722).

4. Dispositif électronique habitronique (101) selon l'une quelconque des revendications 1 à 3, dans lequel la zone de bord extérieur (2711) présente une largeur égale ou inférieure à une première valeur spécifiée et s'étend le long d'au moins une partie de chaque périmètre de la pluralité d'éléments électriques (275).

5. Dispositif électronique habitronique (101) selon la revendication 4, dans lequel la première valeur spécifiée est de 100 µm à 500 µm.

6. Dispositif électronique habitronique (101) selon l'une quelconque des revendications 1 à 5, dans lequel la pluralité d'éléments électriques (275) sont disposés pour être espacés les uns des autres du périmètre de la première couche de carte de circuit imprimé (270-1).

7. Dispositif électronique habitronique (101) selon l'une quelconque des revendications 1 à 6, dans lequel au moins une partie de la zone de bord extérieur (2711) est disposée entre le périmètre de la première couche de carte de circuit imprimé (270-1) et au moins l'un de la pluralité d'éléments électriques (275).

8. Dispositif électronique habitronique (101) selon l'une quelconque des revendications 1 à 7,
dans lequel au moins une partie du ou des motifs conducteurs de la première zone conductrice (271) fait au moins partie d'une zone de terre disposée sur la première couche de carte de circuit imprimé (270-1).

9. Dispositif électronique habitronique (101) selon l'une quelconque des revendications 1 à 8, dans lequel l'ensemble de carte de circuit imprimé (270) comprend en outre :
une seconde couche de carte de circuit imprimé (270-2) disposée sur une surface de la première couche de carte de circuit imprimé (270-1) ; et
au moins un trou traversant (276) conducteur disposé entre la première couche de carte de circuit imprimé (270-1) et la seconde couche de carte de circuit imprimé (270-2) et configuré pour connecter électriquement la première couche de carte de circuit imprimé (270-1) et la seconde couche de carte de circuit imprimé (270-2).

10. Dispositif électronique habitronique (101) selon la revendication 9, dans lequel la pluralité d'éléments électriques (275) sont disposés sur une première surface (210A) de la première couche de carte de circuit imprimé (270-1), et
dans lequel la seconde couche de carte de circuit imprimé (270-2) est disposée dans une direction dans laquelle une seconde surface (210B) de la première couche de carte de circuit imprimé (270-1) fait face, qui est opposée à la première surface (210A) de la première couche de carte de circuit imprimé (270-1), par rapport à la première couche de carte de circuit imprimé (270-1).

11. Dispositif électronique habitronique (101) selon la revendication 9 ou 10, dans lequel la seconde couche de carte de circuit imprimé (270-2) comprend une seconde zone conductrice (277) sur laquelle est formé au moins un motif conducteur et une seconde zone non conductrice (278) formée autour de la seconde zone conductrice (277), et
dans lequel le ou les trous traversants (276) sont connectés électriquement à une partie de la première zone conductrice (271) et à une partie de la seconde zone conductrice (277), respectivement.

12. Dispositif électronique habitronique (101) selon la revendication 11, dans lequel au moins une partie du ou des motifs conducteurs de la seconde zone conductrice (277) fait au moins partie d'une zone de terre disposée sur la seconde couche de carte de circuit imprimé (270-2).

13. Dispositif électronique habitronique (101) selon l'une quelconque des revendications 1 à 12, dans lequel l'ensemble de bobine (280) comprend au moins une bobine de recharge séparée de l'ensemble de carte de circuit imprimé (270) et configurée pour générer un courant induit en réponse à un champ électromagnétique généré depuis l'extérieur du dispositif électronique habitronique (101).

14. Dispositif électronique habitronique (101) selon la revendication 13, comprenant en outre :
une batterie (189) disposée à l'intérieur du boîtier (110 ; 210) ; et
un circuit de recharge sans fil connecté électriquement à la batterie (189) et configuré pour recharger la batterie (189) à l'aide d'un courant induit généré dans la bobine de recharge.

15. Dispositif électronique habitronique (101) selon l'une quelconque des revendications 1 à 14, dans lequel la zone de bord extérieur (2711) s'étend le long d'au moins une partie de chaque périmètre de la pluralité d'éléments électriques (275), et/ou
dans lequel au moins une partie d'une pluralité de portions de la zone de bord extérieur (2711), qui sont en contact avec les zone fendues (2722) respectives, est séparée par la zone fendue (2722).
